Europäisches Patentamt

European Patent Office

Office européen des brevets

(19)

(11) Numéro de publication : **0 498 702 A1**

(12) # DEMANDE DE BREVET EUROPEEN

(21) Numéro de dépôt : **92400259.5**

(22) Date de dépôt : **31.01.92**

(51) Int. Cl.$^5$ : **H01L 21/58, H01L 21/68, H01L 21/98**

(30) Priorité : **04.02.91 FR 9101232**

(43) Date de publication de la demande :
**12.08.92 Bulletin 92/33**

(84) Etats contractants désignés :
**DE GB**

(71) Demandeur : **FRANCE TELECOM**
**6 place d'Alleray**
**F-75015 Paris (FR)**

(72) Inventeur : **Schiltz, André**
**85 Allée Chamrousse**
**F-38330 Saint-Ismier (FR)**
Inventeur : **Thevenot, Louis**
**3, allée de la Piat**
**F-38240 Meylan (FR)**
Inventeur : **Vareille, Aimé**
**3, rue Gabrielle Didier**
**F-38130 Echirolles (FR)**

(74) Mandataire : **Casalonga, Alain**
**BUREAU D.A. CASALONGA - JOSSE**
**Morassistrasse 8**
**W-8000 München 5 (DE)**

(54) **Procédé et dispositif d'insertion de puces dans des logements d'un substrat par film intermédiaire.**

(57) Procédé d'insertion de puces dans des logements ménagés dans un substrat notamment du type hybride, consistant, avant de fixer les puces (1a) dans les logements précités (2a), à maintenir les puces (1a) respectivement dans les logements précités (2a) par l'intermédiaire d'un film (6) qui est collé sur l'une des faces du substrat (3) et sur lequel sont collées les puces.

FIG.3

EP 0 498 702 A1

La présente invention concerne le report de puces sur substrats notamment du type hybride multicouches et plus particulièrement les techniques d'insertion d'une ou de plusieurs puces ou de composants dans des logements ménagés dans un substrat.

Les progrès effectués ces dernières années dans le domaine de la conception et de la réalisation de circuits intégrés ou puces ont permis de miniaturiser considérablement ces composants. Aujourd'hui, les possibilités de réduction de la taille des puces se trouvent limitées. On cherche donc depuis quelques années à réduire les distances entre composants associés afin de miniaturiser voire transformer les circuits imprimés classiques en vue de la fabrication de ce que l'on appelle parfois des "superpuces" qui sont constituées de puces reportées sur des réseaux multicouches d'interconnexion de petites dimensions.

Pour effectuer le report de puces nues directement rapportées sur un substrat, on connaît aujourd'hui principalement trois méthodes.

La première consiste à coller la puce sur le substrat puis à interconnecter la puce et le réseau du substrat grâce à des fils métalliques soudés. Les inconvénients de cette technique de liaison classique par fils résultent de la fragilité des fils et de la soudure fil-plot ainsi que de l'encombrement d'une telle structure

Une seconde technique dite de "flip-chip" permet de souder directement les plots de la puce aux plots du substrat, la puce étant posée ou collée sur le substrat. Les inconvénients de cette technique résident d'une part dans la difficulté d'aligner à l'envers les plots de la puce et ceux du substrat et d'autre part dans la difficulté de réaliser la soudure des différents plots sans engendrer de contraintes mécaniques.

Une troisième technique consiste à introduire les puces nues dans respectivement des logements préalablement exécutés dans le substrat, à les coller et à connecter les plots des puces aux plots du substrat par la réalisation à l'aide d'outils microlithographiques de chemins électroconducteurs de surface.

Dans une première variante proposée, le substrat qui comportent le réseau d'interconnexion et les logements destinés ultérieurement à l'insertion des puces est collé sur un deuxième substrat plan.

Dans une deuxième variante proposée, on utilise un substrat plan de référence sur lequel on applique un feuillard d'aluminium recouvert d'un agent de démoulage du type polytétrafluoréthylène puis on plaque chaque puce à l'aide d'un clip de serrage et on dépose la colle de fixation des puces au substrat en face arrière de ces derniers, l'ensemble étant, après collage des puces, démoulé et les plots des puces et du substrat étant reliés par métallisation.

Les inconvénients des techniques d'insertion ci-dessus sont les suivants. Dans les deux variantes proposées, l'espace entre les puces et le substrat est relativement large, ce qui conduit à un certain désalignement et à une difficulté de centrage des puces dans leur logement. La colle de scellement est déposée de manière peu précise, ce qui laisse une tranchée en face arrière du substrat, qui génère des problèmes d'isolation thermique et des problèmes de planéité et de remplissage lors de l'étape de lithographie des contacts interplots. Dans la première variante proposée, le substrat supplémentaire ajouté de manière permanente empêche une bonne dissipation thermique en face arrière du substrat et des puces et empêche toute réparation ultérieure. Dans la seconde variante proposée, la nécessité d'utiliser un clip de serrage par puce à reporter sur un substrat engendre un encombrement tel que le report de plusieurs puces paraît fastidieux.

Le but de la présente invention est de proposer un procédé d'insertion de puces dans des logements ménagés dans un substrat qui ne présente pas les inconvénients des méthodes connues.

Selon un objet de l'invention, le procédé consiste, avant de fixer les puces dans les logements précités, à maintenir les puces respectivement dans les logements précités par l'intermédiaire d'un film qui est collé sur l'une des faces du substrat et sur lequel sont collées les puces.

Dans une exécution préférée de l'invention, le procédé consiste, dans une première phase, à coller le film intermédiaire de maintien précité contre l'une des faces du substrat et, dans une seconde phase, à engager respectivement dans les logements précités les puces et à les coller contre le film intermédiaire de maintien.

Le procédé de l'invention consiste de préférence, avant d'engager les puces dans les logements du substrat, à placer ce dernier à plat sur un support plan de telle sorte que le film précité s'étende entre eux.

Le procédé de l'invention consiste, de préférence, à coller le film intermédiaire de maintien contre la face avant du substrat du type hybride, les puces étant fixées face avant contre ce film.

Le procédé de l'invention consiste à insérer les puces dans les logements du substrat de telle sorte qu'il subsiste de préférence un espace tout autour des puces.

Selon un autre objet de l'invention, le procédé consiste, après collage des puces contre le film intermédiaire de maintien, à injecter dans l'espace séparant les puces des parois des logements qui les reçoivent une matière de scellement qui, après durcissement, les maintient fixées au substrat.

Dans une variante, le procédé selon l'invention consiste à utiliser un film autocollant et, après durcissement de la matière de scellement, à enlever par pelage ce film.

Dans une autre variante, le procédé de l'invention consiste à fixer à demeure le substrat et les puces sur le film intermédiaire de maintien.

Le procédé de l'invention peut avantageusement consister à utiliser un film collant par réaction, à coller localement ce dernier sur le substrat et à coller localement les puces sur ce film, par exemple par chauffage ou rayonnement ultraviolet.

Le procédé peut en outre consister, après insertion des puces, à coller par réaction le film sur toute sa surface, par exemple par chauffage ou rayonnement ultraviolet.

Selon l'invention, le procédé consiste avantageusement, après scellement des puces, à effectuer les interconnections entre les puces et le réseau du substrat du type hybride en traversant le film précité.

De préférence, selon l'invention, le procédé consiste à utiliser une matière de scellement fluide pénétrant dans l'espace entre puces et substrat par capillarité.

La présente invention a également pour objet un substrat notamment du type hybride présentant au moins un logement traversant pour l'insertion d'une puce, qui présente des flancs droits et dans la paroi duquel est ménagée au moins une partie en creux ou entaille.

La présente invention a également pour objet un substrat notamment du type hybride présentant au moins un logement traversant pour l'insertion d'une puce, qui est dimensionné de telle sorte qu'il subsiste entre la paroi périphérique de la puce et sa paroi un espace annulaire d'épaisseur comprise entre 20 et 100 microns.

La présente invention a également pour objet un dispositif d'insertion d'une puce dans un logement traversant d'un substrat notamment du type hybride, qui comprend une tête d'insertion sur laquelle la puce est maintenue par succion et qui est adaptée pour maintenir la puce dans le logement sous l'effet d'une force déterminée ou contrôlée, contre une surface d'appui, par exemple le film précité.

La présente invention sera mieux comprise à l'étude de procédés d'insertion de puces dans des logements ménagés dans un substrat notamment du type hybride multicouches décrit à titre d'exemples non limitatifs en référence au dessin sur lequel :

— les figures 1 à 5 montrent schématiquement les étapes d'un premier procédé d'insertion selon l'invention ;

— les figures 6 à 9 montrent schématiquement les étapes d'un second procédé d'insertion selon l'invention ;

— la figure 10 montre schématiquement une tête d'insertion ;

— et les figures 11 et 12 montrent un moyen particulier de scellement d'une puce.

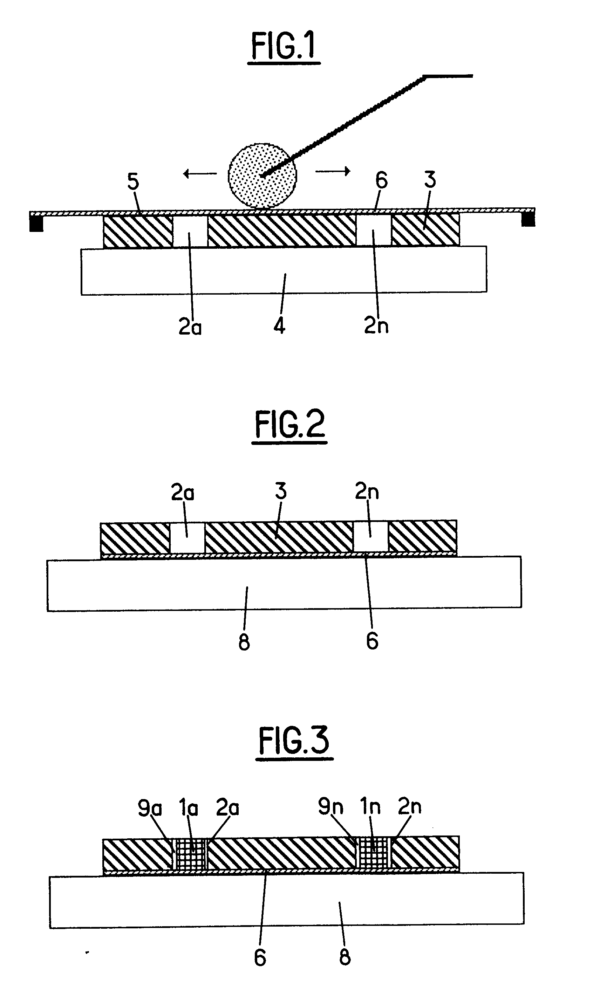

Le procédé illustré sur les figures 1 à 5 est destiné à l'insertion de plusieurs puces 1a-1n dans respectivement des logements 2a-2n de forme correspondante et ménagés au travers d'un substrat 3 notamment de type hybride multicouches se présentant sous la forme d'une plaque.

Tout d'abord, comme le montre la figure 1, on pose la plaque 3 sur la face supérieure d'un support 4, la face avant 5 du substrat 3 qui présente le réseau d'interconnexion étant tournée vers le haut. On tend et on colle sur la face avant 5 du substrat 3 un film souple adhésif 6 par exemple en polychlorure de vinyle autocollant sur sa face inférieure, que l'on applique par exemple à l'aide d'un rouleau d'étalement en caoutchouc 7.

Ensuite, on découpe autour du substrat 3 le film 6 et on place le substrat 3 sur une plaque 8 de telle sorte que le film 6 s'étende entre cette plaque 8 et le substrat 3, cette plaque 8 étant plane et transparente aux rayons ultraviolets, de préférence en quartz, comme le montre la figure 2.

Dans l'étape suivante visible sur la figure 3, on engage les puces 1a-1n dans respectivement les logements 2a-2n, en engageant en premier leurs faces avant munies de plots de connexion, jusqu'à amener leurs faces avant en contact avec le film adhésif 6 et ainsi les coller sur ce film dans une position telle qu'il subsiste entre la paroi périphérique des puces 1a-1n et la paroi des logements 2a-2n des espaces annulaires 8a-8n de préférence régulière. Ainsi, les faces avant des puces 1a-1n s'étendent dans le même plan que la face avant du substrat 3.

Dans l'exemple représenté, les puces 1a-1n sont de forme parallélipipédique et présentent des côtés qui peuvent avoir des dimensions comprises entre 1 à 10 millimètres de côté et une épaisseur comprise entre 0,2 et 1 mm. Les logements 2a-2n sont de section carrée ou rectangulaire de forme correspondante et sont à flancs droits s'étendant perpendiculairement aux faces du substrat 3. Les logements 2a-2n sont dimensionnés de telle sorte que les spaces 9a-9n entre les puces 1a-1n et la paroi des logements 2a-2n qui les reçoivent soient de préférence compris entre 20 et 100 microns. De plus, l'épaisseur du substrat 3 est de préférence égale ou légèrement supérieure à l'épaisseur des puces 2a-2n.

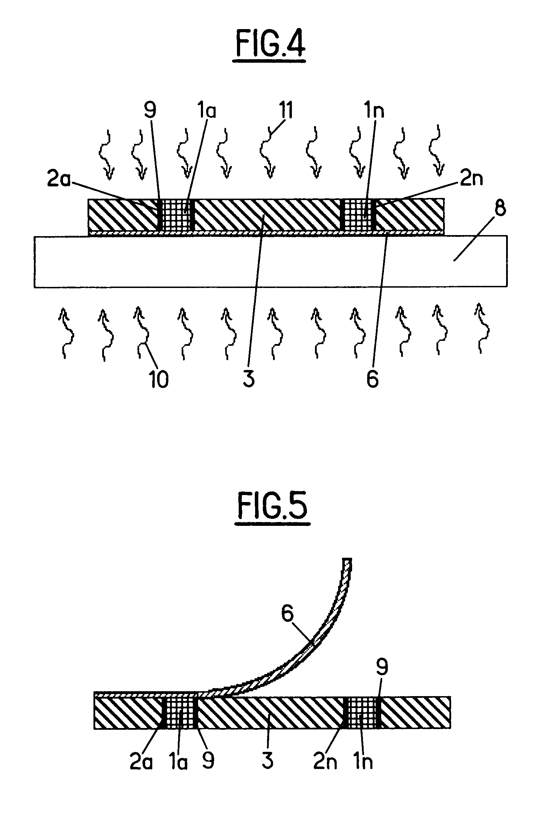

Dans l'étape ultérieure représentée sur la figure 4, on introduit dans les espaces 9a-9n précités, par la face supérieure arrière du substrat 3 opposée au film adhésif 6, une matière de scellement 9 ou colle de préférence très fluide qui par capillarité les remplit de préférence complètement. Cette matière de scellement 9 peut être une résine thermoréticulable chargée ou non d'éléments thermoconducteurs. On peut noter que la matière de scellement introduite dans les espaces 9a-9n est retenue par le film adhésif 6 et en conséquence ne pénètre pas entre ce dernier et les faces avant du substrat 3 et des puces 2a-2n.

On procède alors au durcissement simultané de la matière de scellement 9 introduite dans les espaces 9a-9n par exemple par un traitement thermique et en particulier par photoréticulation par un rayonnement ultraviolet 10 émis en face avant du substrat 3 au travers de la plaque support 8 et du film adhésif 6 transparents aux rayons ultraviolets et/ou par un rayonnement ultraviolet 11 émis en direction de la face arrière du substrat 3.

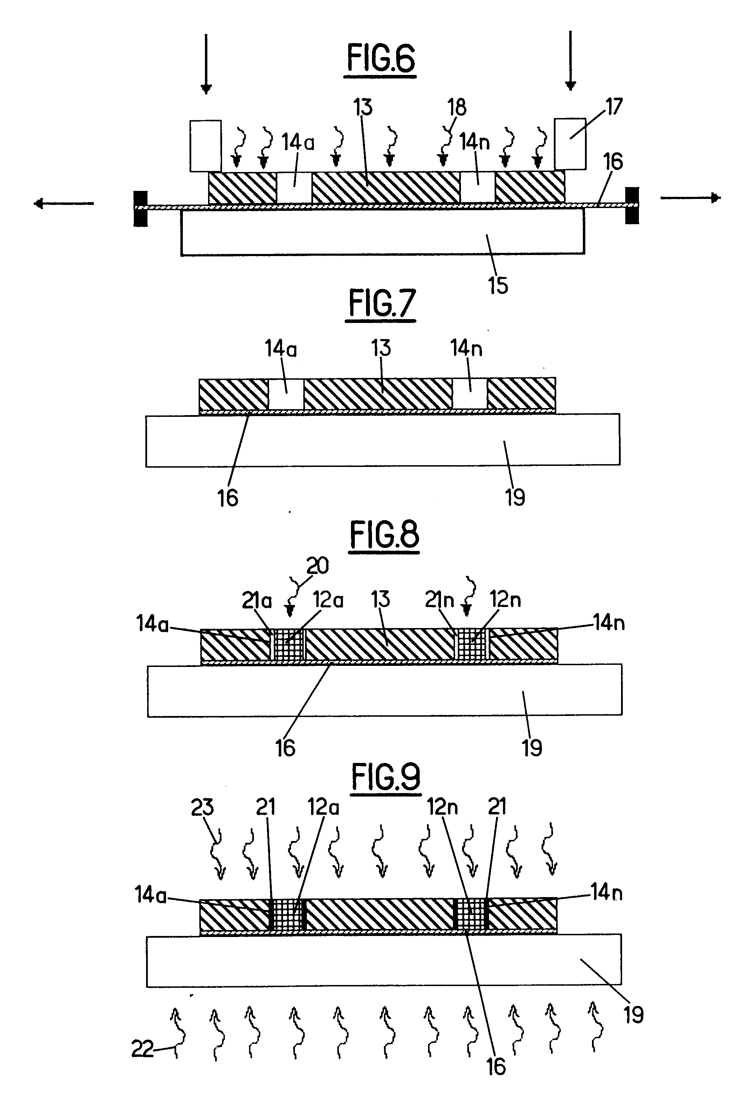

Dans l'étape suivante représentée sur la figure 5, après durcissement de la matière de scellement 9, simultanément pour toutes les puces, on procède à l'arrachage par pelage du film adhésif 6. On peut alors procéder à l'exécution des connexions électriques entre les plots des puces 2a-2n et le réseau d'interconnexion prévu en face avant 5 du substrat 3.

En se reportant maintenant aux figures 6 à 8, on va décrire un autre procédé d'insertion de puces 12a-12n dans un substrat 13 dans lequel sont ménagés des logements 14a-14n qui sont dimensionnés comme dans l'exemple précédent.

Dans une première étape représentée sur la figure 6, on étend sur un support plan 15 un film 16 en le tendant, ce film étant par exemple un polyimide non cyclisé sur sa face supérieure ou un époxyde non antérieurement réticulé.

On pose le substrat 13 sur la face supérieure du film 16 et on exerce sur ce dernier une pression par exemple grâce à un cadre d'appui 17, la face avant présentant le réseau d'interconnexion du substrat 13 étant contre le film 16.

Grâce à des moyens non représentés, on émet un rayonnement ultraviolet 18 par exemple en direction de la face arrière du substrat 13, ce faisceau 18 étant localisé ou délimité en surface de manière à transformer la matière du film 16 pour provoquer son collage sur la face avant du substrat 13 en dehors des zones correspondant aux logements 14a-14n.

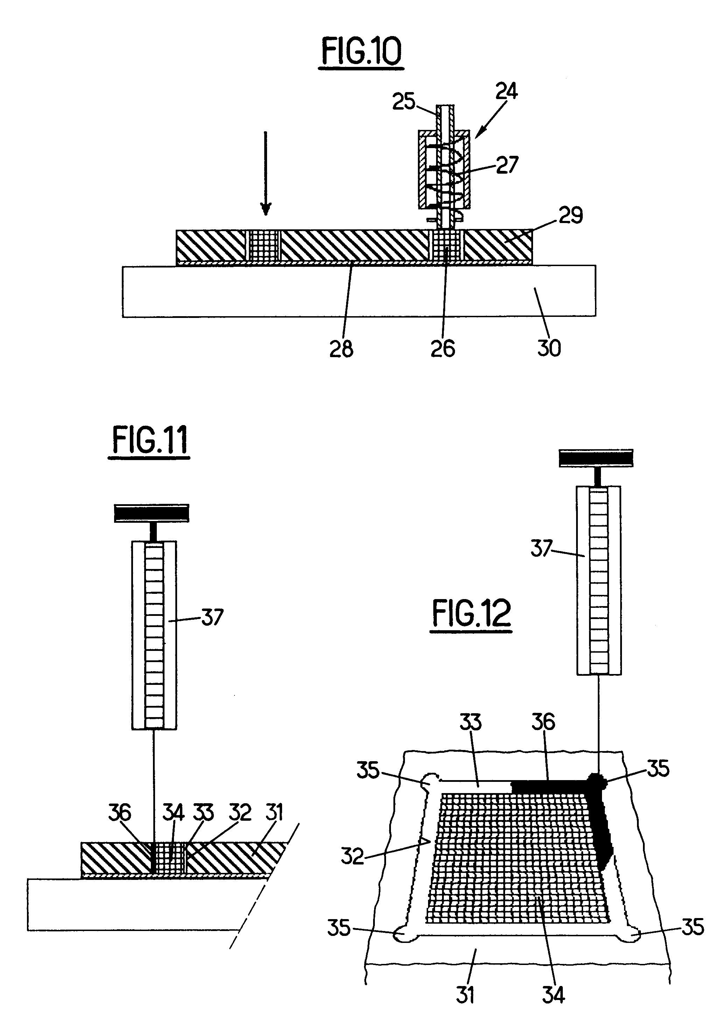

On découpe le film 16 autour du substrat 13 collé localement sur la face avant de ce dernier et on le pose sur la face supérieure d'une plaque plane 19 transparent aux rayons ultraviolets de préférence en quartz, le film 16 s'étendant entre cette plaque 19 et le substrat 13, comme le montre la figure 8.

On engage alors, leur face avant en premier, les puces 12a-12n dans respectivement les logements 14a-14n du substrat 13 jusqu'à les poser sur le film 16 dans des positions telles qu'il subsiste, comme précédemment, des espaces annulaires 21a-21n de préférence réguliers entre les puces 12a-12n et les parois des logements 14a-14n. On émet alors un rayonnement ultraviolet 20 localisé permettant le collage des puces 12a-12n sur le film 16.

Ensuite, comme le montre la figure 9, on introduit, comme dans l'exemple décrit en référence aux figures 1 à 6, de la matière de scellement 21 dans les espaces 21a-21n séparant les puces 12a-12n des parois des logements 14a-14n du substrat 13 puis on émet un rayonnement ultraviolet 22 par en-dessous et un rayonnement ultraviolet 23 par en-dessus grâce à des moyens non représentés, sur toute la surface du substrat 13, de manière à provoquer le durcissement de la matière de scellement et de manière à régulariser le collage du film 16 sur toute la face avant du substrat 13 et sur toute la face avant des puces 12a-12n.

Dans cette exécution, le film 16 est destiné à rester à demeure sur le substrat 13. Ultérieurement, on effectue les connexions électriques entre les plots des puces 12a-12n et le réseau d'interconnexion du substrat 13 au travers du film 16.

Dans les exemples qui sont décrits ci-dessus, les puces 1a-1n et les puces 12a-12n peuvent être introduites et positionnées manuellement en utilisant bien entendu un microscope. Cependant, comme le montre la figure 10, on peut utiliser une tête d'insertion repérée d'une manière générale par la référence 24 qui comprend un tube d'aspiration 25 qui permet de maintenir à son extrémité, par succion de sa face arrière, une puce 26 à insérer et qui comprend un ressort 27 qui, par combinaison des effets de ce ressort 27 et du déplacement vertical du tube 25 permet d'appliquer avec une force déterminée la puce 26 contre le film 28 collé contre une face du substrat 29 et en appui sur la plaque 30. Naturellement, la tête d'insertion 24 est de préférence montée sur un chariot mobile de transfert et de positionnement et son tube 25 est relié à une source de dépression, qui ne sont pas représentés. Dans le cas d'insertion de plusieurs puces dans les logements d'un même substrat, ce chariot pourrait porter plusieurs têtes d'insertion qui seraient alors mobiles simultanément.

En se reportant maintenant aux figures 11 et 12, on voit qu'on a prévu dans un substrat 31 un logement d'insertion 32 de section rectangulaire ou carrée à flancs droits qui délimite un espace annulaire 33 entre sa paroi et la paroi périphérique d'une puce parallélipipédique 34 et qu'on a ménagé aux quatre coins du logement 32 des parties en creux ou entailles 35 cylindriques sur l'épaisseur du substrat par lesquelles on peut aisément injecter la matière de scellement liquide 36 grâce par exemple à une seringue 37, la matière de scellement remplissant l'espace 33 par capillarité. De préférence, la matière de scellement utilisée présente une viscosité comprise entre 10 et 10 000 centipoises.

La présente invention ne se limite pas aux exemples ci-dessus décrits. Bien des variantes de réalisation sont possibles sans sortir du cadre défini par les revendications annexées.

## Revendications

1. Procédé d'insertion de puces présentant une face avant munie de plots de connexion, dans des logements ménagés dans un substrat notamment du type hybride présentant un réseau d'interconnexion sur sa face avant, caractérisé par le fait qu'il consiste à maintenir les puces (1a) respectivement dans les logements précités (2a) par l'intermédiaire d'un film (6) qui est collé sur ladite face avant du substrat (3) et sur lequel sont collées lesdites faces avant des puces, puis à fixer les puces ou substrat (1a) dans un logement précité (2a), les connexions plots-réseau étant réalisées ultérieurement.

2. Procédé selon la revendication 1, caractérisé par le fait qu'il consiste, dans une première phase, à coller le film intermédiaire de maintien précité (6) contre l'une des faces du substrat (3) et, dans une seconde phase, à engager respectivement dans les logements précités (2a) les puces (1a) et à les coller contre le film intermédiaire de maintien.

3. Procédé selon l'une des revendications précédentes, caractérisé par le fait qu'il consiste, avant d'engager les puces (1a) dans les logements (2a) du substrat (3), à placer ce dernier à plat sur un support plan (4) de telle sorte que le film précité (6) s'étende entre eux.

4. Procédé selon l'une quelconque des revendications précédentes, caractérisé par le fait qu'il consiste à insérer les puces (1a) dans les logements (2a) du substrat (3) de telle sorte qu'il subsiste un espace (9a) tout autour des puces.

5. Procédé selon la revendication 4, caractérisé par le fait que l'épaisseur dudit espace (9a) est comprise entre 20 et 100 microns.

6. Procédé selon l'une quelconque des revendications précédentes, caractérisé par le fait qu'il consiste, après collage des puces (1a) contre le film intermédiaire de maintien (6), à injecter dans l'espace (9a) séparant les puces des parois des logements (2a) qui les reçoivent une matière de scellement (9) qui, après durcissement, les maintient fixées au substrat (3).

7. Procédé selon la revendication 6, caractérisé par le fait qu'il consiste à utiliser un film auto-collant (6) et, après durcissement de la matière de scellement (9), à enlever par pelage ce film.

8. Procédé selon la revendication 6, caractérisé par le fait qu'il consiste à fixer à demeure le substrat (13) et les puces (12a) sur le film intermédiaire de maintien (16).

9. Procédé selon la revendication 8, caractérisé par le fait qu'il consiste à utiliser un film (16) collant par réaction, à coller localement ce dernier sur le substrat (13) et à coller localement les puces (12a) sur ce film.

10. Procédé selon la revendication 9, caractérisé par le fait qu'il consiste, après insertion des puces, à coller par réaction toute la surface du film (16).

11. Procédé selon l'une quelconque des revendications 8 à 10, caractérisé par le fait qu'il consiste, après scellement des puces, à effectuer les interconnexions entre les puces et le réseau du substrat du type hybride en traversant le film précité.

12. Procédé selon l'une quelconque des revendications précédentes, caractérisé par le fait qu'il consiste à utiliser une matière de scellement fluide pénétrant dans l'espace entre puces et substrat par capillarité.

13. Procédé selon l'une quelconque des revendications précédentes, caractérisé par le fait qu'il consiste, lors de la fixation des puces (1a) dans les logements précités (2a), à maintenir les puces contre le film (6) sous l'effet d'une force déterminée ou contrôlée.

14. Substrat (31) notamment du type hybride présentant au moins un logement traversant pour l'insertion d'une puce, caractérisé par le fait que ce logement (32) présente des flancs droits, au moins une partie en creux ou entaille (35) étant ménagée dans sa paroi.

15. Dispositif d'insertion d'une puce dans un logement traversant d'un substrat notamment du type hybride, caractérisé par le fait qu'il comprend une tête d'insertion (24) sur laquelle la puce (26) est maintenue par succion et qui est adaptée pour maintenir la puce dans le logement sous l'effet d'une force déterminée on contrôlée, contre une surface d'appui d'un support sur lequel est posé le substrat.

EP 0 498 702 A1

# FIG.1

# FIG.2

# FIG.3

6

# FIG.4

# FIG.5

FIG.6

FIG.7

FIG.8

FIG.9

## FIG.10

## FIG.11

## FIG.12

Office européen
des brevets

**RAPPORT DE RECHERCHE EUROPEENNE**

Numero de la demande

EP 92 40 0259

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN<br>vol. 9, no. 15 (E-291)(1738) 22 Janvier 1985<br>& JP-A-59 161 831 ( NIPPON DENKI K.K. ) 12 Septembre 1984<br>* abrégé * | 1,2,4,5, 6,8,10, 12 | H01L21/58<br>H01L21/68<br>H01L21/98 |
| | --- | | |
| A | GB-A-2 202 673 (H. AHMED ET AL.)<br>* page 5, ligne 22 - page 7, ligne 27 *<br>* abrégé *<br>* figure 2 * | 1,3 | |
| | --- | | |
| A | EP-A-0 231 937 (HITACHI MAXELL LTD.)<br>* page 9, ligne 22 - ligne 30; figures 8,9 * | 1,3 | |
| | --- | | |
| Y | PATENT ABSTRACTS OF JAPAN<br>vol. 5, no. 44 (E-50)(716) 24 Mars 1981<br>& JP-A-55 165 641 ( HITACHI SEISAKUSHO K.K. ) 24 Décembre 1980<br>* abrégé * | 15 | |
| | --- | | **DOMAINES TECHNIQUES RECHERCHES (Int. Cl.5)** |
| Y | PATENT ABSTRACTS OF JAPAN<br>vol. 7, no. 62 (E-164)(1207) 15 Mars 1983<br>& JP-A-57 210 636 ( HITACHIT SEISAKUSHO K.K. ) 24 Décembre 1982<br>* abrégé * | 15 | H01L |
| | ----- | | |

Le présent rapport a été établi pour toutes les revendications

| Lieu de la recherche | Date d'achèvement de la recherche | Examinateur |
|---|---|---|
| LA HAYE | 17 MARS 1992 | PROHASKA G.A.F. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.12 (P0402)